# EUROPEAN PATENT APPLICATION

(11) **EP 1 150 353 A2**
(43) Date of publication of application: **31.10.2001**
(21) Application number: 01303801.3
(22) Date of filing: 26.04.2001
(51) Int. Cl.: H01L 27/02, H01L 21/8238

(54) **Using lightly doped resistor for output stage electrostatic discharge protection**

(30) Priority: 26.04.2000 US 559116
(71) Applicant: SHARP KABUSHIKI KAISHA, Osaka 545-8522 (JP)
(72) Inventor: Hsu, Sheng Teng, Camas, WA 98607 (US)
(74) Representative: Brown, Kenneth Richard

(57) **Abstract**

A method of fabricating a CMOS device having improved electrostatic discharge protection properties includes preparing a silicon substrate; forming an n-well for a pMOS active region; forming a p-well for an nMOS active region; and implanting ions to form a lightly doped drain series resistor in at least on of the active regions. An electrostatic discharge protection structure for use in a CMOS device having a pMOST and an nMOST therein includes an electrostatic triggering structure to uniformly trigger both pMOST and nMOST output to protect against positive and negative electrostatic discharge events.

## Description

### Field of the Invention

This invention relates to electrostatic discharge protection for CMOS integrated circuits, and specifically to the provision of a lightly doped region forming a resistor in an active region of such an integrated circuit.

### Background of the Invention

In the case of CMOS transistors, particularly those having longer channel lengths, there is difficulty in obtaining uniform electrostatic discharge (ESD) current flow. The provision of an n⁻ well drain series resistor in CMOS transistors is useful only in nMOS devices, and then only in n⁻ well structures, and only protects against a positive ESD event at the output pad. The use of an n⁺ drain-to-p⁻ substrate junction diode is known, however, this arrangement only protects against negative ESD events, and requires the presence of an n⁻ well in a portion of the drain junction.

A drain junction may be separated with local oxidation of silicon (LOCOS) techniques at the edge of an n⁻ well to increase the uniformity of triggering of positive ESD events to the output stage, however, the ESD properties of pMOS devices of the output CMOS inverter have not been improved, and there is no known ESD protection for a pMOS device. Known ESD structures are not operable with CMOS devices fabricated on n-type silicon substrates.

The use of n⁻ well resistor providing ESD protection for semiconductor devices has been described by G. Notermans, "On the use of n⁻ well resistors for uniform triggering of ESD protection elements," EOS/ESD Symposium Proceedings, page 221, 1997.

### Summary of the Invention

A method of fabricating a CMOS device having improved electrostatic discharge protection properties includes preparing a silicon substrate; forming an n⁻ well for a pMOS active region; forming a p⁻ well for an nMOS active region; and implanting ions to form a lightly doped drain series resistor in at least one of the active regions.

An electrostatic discharge protection structure for use in a CMOS device having a pMOST and an nMOST therein includes an electrostatic triggering structure to uniformly trigger both pMOST and nMOST output to protect against positive and negative electrostatic discharge events.

It is an object of the invention to provide an improved electrostatic discharge protection structure.

Another object of the invention is to provide such an EDS structure which is smaller than known ESD structures.

A further object of the invention is to provide an ESD structure which will be operable with all types of CMOS integrated circuits.

Yet another object of the invention is :o provide an ESD structure which causes uniform triggering to both nMOS and pMOS output transistors to provide protection for both positive and negative ESD events.

Still another object of the invention is to provide and ESD structure suitable for use with CMOS devices fabricated on n-type substrates and on p-type substrates.

This summary and objectives of the invention are provided to enable quick comprehension of the nature of the invention. A more thorough understanding of the invention may be obtained by reference to the following detailed description of the preferred embodiment of the invention in connection with the drawings.

### Brief Description of the Drawings

Figs. 1 - 4 depict successive steps in the fabrication of a device according to a first embodiment of the invention.

Fig. 5 and 6 depict successive steps in the fabrication of a device according to a second embodiment of the invention.

### Detailed Description of the Preferred Embodiment

The electrostatic discharge (ESD) protection structure of the invention provides an improved and smaller size output protection for CMOS integrated circuits. It provides uniform triggering to both nMOS and pMOS output transistors to provide protection for both positive and negative ESD events. The structure may be applied to CMOS devices fabricated on n-type substrates, as well as fabricated on p-type substrates.

The addition of a series resistance to the drain of the device makes the second breakdown voltage larger than the first breakdown voltage, which provides uniform triggering of the output transistor and uniform ESD current flow. This protects against both positive and negative ESD events at the output of the CMOS integrated circuit. The lightly doped (LDD) resistor may be incorporated into any standard CMOS fabrication process, generally, without any additional masking steps or any additional process steps. Only the n⁺ and p⁺ ion implantation mask has to be modified.

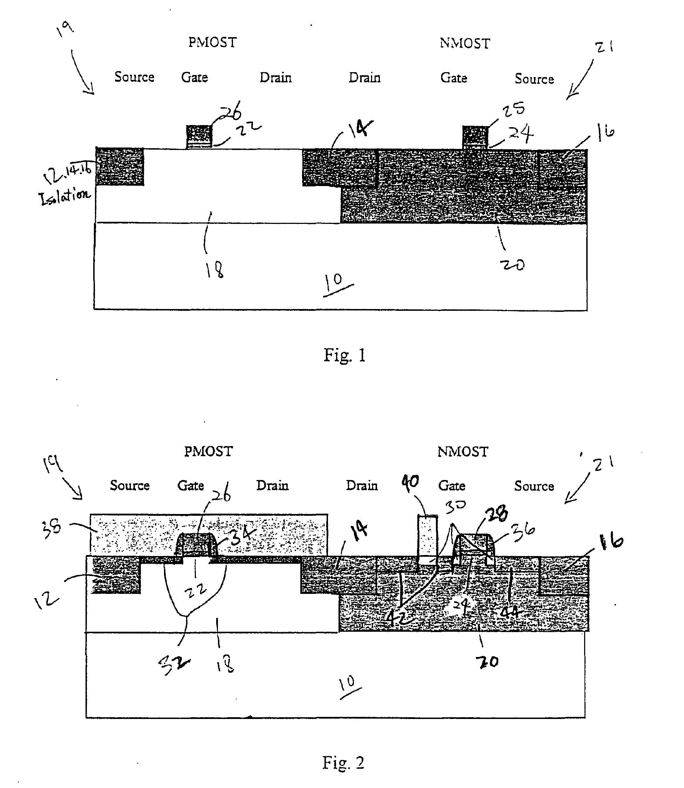

The fabrication process is described in conjunction with the drawings, beginning with Fig. 1. A substrate 10 is prepared for CMOS fabrication. Substrate 10 may be a single crystal silicon, a silicon-on-insulator (SOI) substrate, or a separation by implantation of oxygen (SIMOX) substrate. Isolation regions 12, 14 and 16 are formed by local oxidation of silicon (LOCOS) or shallow trench isolation (STI), or any other state of the art isolation process, such as mesa for SOI devices. State of the art processes are followed to form an n-well active region 18, which will form an active region for a pMOST 19, and a p-well active region 20, which will form an active region for a nMOST 21. Threshold adjustment ion implantation, gate oxidation to form gate oxide layers 22, 24, and gate electrode formation to form gate electrodes 26, 28, are accomplished by any state of the art processes for pMOS transistor 19 and nMOS transistor 21, respectively. The term "pMOST" as used herein refers to a pMOS transistor. The term "nMOST" as used herein refers to an nMOS transistor.

Referring now to Fig. 2, a mask (not shown) is applied to protect nMOS region 21. Phosphorus or arsenic ions are implanted to form n-type LDD region 30 in nMOS 21. In order to form the nLDD region, arsenic ions are implanted at an energy of between 20 keV and 50 keV (if phosphorous ions are used, the implant energy range is preferably 10 keV to 50 keV), at a dose of between 1 x 10¹² cm⁻² and 1 x 10¹⁴ cm⁻², resulting in an ion concentration of between 1 x 10¹⁸ cm ⁻³ and 1 x 10²⁰ cm⁻³. The mask is stripped, and a second mask (also not shown) is applied prior to the implantation of boron or BF₂ ions, which will form a p-type LDD region 32 in pMOS region 19. To form the pLDD region 32, BF₂ ions are implanted at an energy of between 20 keV and 50 keV (if boron ions are used, the implant energy range is preferably 10 keV to 50 keV), at a dose of between 1 x 10¹² cm⁻² and 1 x 10¹⁴ cm⁻², resulting in an ion concentration of between 1 x 10¹⁸ cm⁻³ and 1 x 10²⁰ cm⁻³. A thin oxide is deposited by chemical vapor deposition (CVD) and anisotropically etched to form a sidewall oxide 34. 36 about gate electrodes 26, 28, respectively.

Next, a two-segment n⁺ ion implantation mask 38, 40 is applied prior to phosphorus or arsenic n⁺ ion implantation. Mask 38 covers all of pMOS transistor 19 and a portion of what will become a drain region of nMOS transistor 21, as shown in Fig. 2. Ion implantation implants n⁺ ions in nMOS 21, forming an nMOS drain 42 and an nMOS source 44. Drain 42 and source 44 are formed by implanting arsenic ions at a dose of 1 x 10¹⁵ cm⁻² to 5.0 x 10¹⁵ cm⁻² at an energy of 20 keV to 50 keV, or, if phosphorus ions are implanted, the implant energy range is preferably 10 keV to 50 keV.

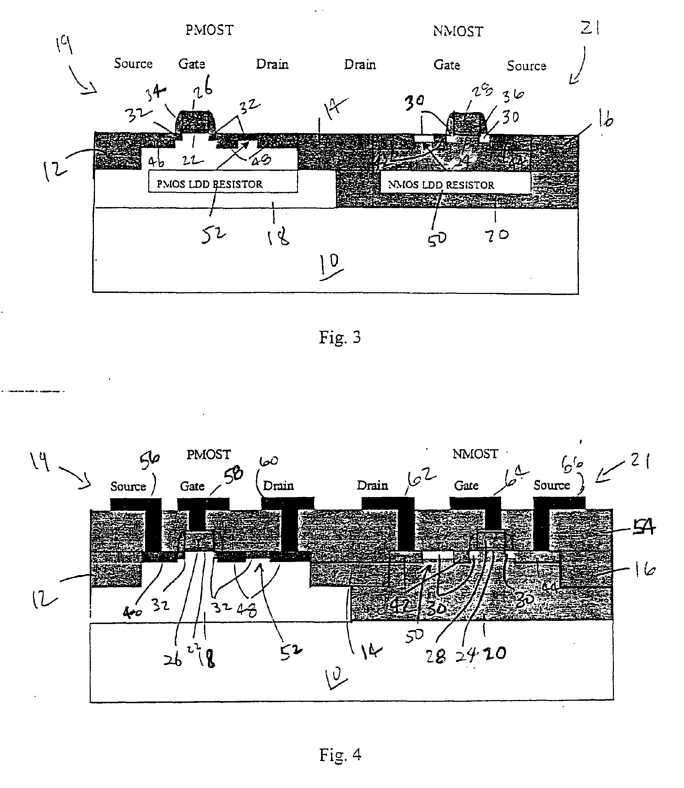

Referring to Fig. 3, the n+ ion implantation mask is removed and another mask (not shown) applied to perform the BF₂, or boron p⁺ ion implantation to form a source 46 and a drain 48 for pMOS 19. Source 46 and drain 48 are, in this instance, formed by implanting BF₂ ions at a dose of 1 x 10¹⁵ cm⁻² to 5.0 x 10¹⁵ cm⁻² at an energy of 20 keV to 50 keV. If boron ions are implanted the implant energy is preferably 10 keV to 50 keV. This mask is then stripped, resulting in the structure depicted in Fig. 3.

In Fig. 3, LDD drain series resistors 50, 52, for nMOS region 21 and pMOS region 19, respectively, are shown. This drain series resistance provides a voltage drop, which prevents the second breakdown of a local weak point before the other portion of the drain breakdown occurs. The addition of a series resistance to the drain of the device makes the second breakdown voltage larger than the first breakdown voltage, which provides uniform triggering of the output transistor and uniform ESD current flow. This protects against both positive and negative ESD events at the output of the CMOS integrated circuit. Therefore, a uniform ESD current flow is possible. Drains series resistors 50, 52 comprise what is referred to herein as an electrostatic triggering structure to uniformly trigger both pMOST and nMOST output to protect against positive and negative electrostatic discharge events.

The final, metallized structure is shown in Fig. 4, where an n⁺ gate is used as an example. A thick layer of oxide 54, such as tetraethylorthosilicate (TEOS) is deposited, contact holes opened and first metal deposited and etched, forming, for pMOST 19, a source electrode 56, a gate electrode 58, and a drain electrode 60. nMOST 21 has a drain electrode 62, a gate electrode 64 and a source electrode 66 operatively connected thereto.

Any gate material may be used with the disclosed structure. Although nLDD resistor 50 is formed in drain 42 of nMOS 21 and pLDD resistor 52 is formed in drain 48 of pMOS 19, the ESD structure will work even if only a single nLDD resistor is added to the drain of the nMOST or only a pLDD resistor is added to the drain of the pMOST. This embodiment may also be used with SOI structures.

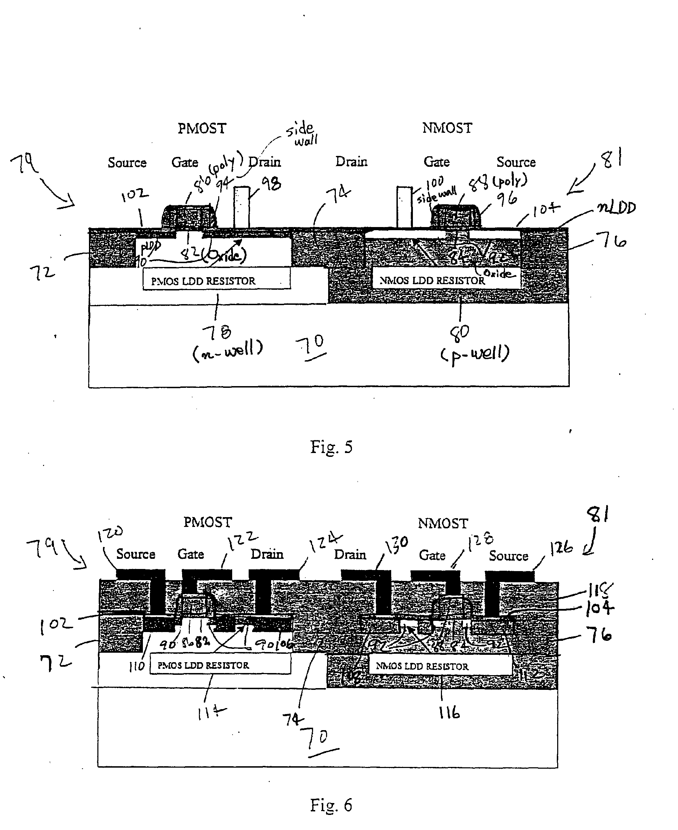

The foregoing process of the first embodiment is for a non-salicide process. For salicide processes, an additional mask is required. Referring now to Fig. 5, a substrate 70 has isolation regions 72, 74 and 76 formed therein. An n⁻ well active region 78 is formed, for a pMOS region 79, which will become a pMOST. A p⁻ well active region 80 is formed, for an nMOS region 81, which will become a nMOST. An oxide layer 82, 84 is deposited, and a gate electrode 86, 88 is also deposited, for pMOS region 79 and nMOS region 81, respectively. A pLDD region 90 and an nLDD region 92 arc formed for pMOS region 79 and nMOS region 81, respectively, and a gate sidewall 94, 96 is deposited.

Selective silicidation takes place on n⁺ and p⁺ areas, but is not allowed to occur on the LDD resistor areas. This may be achieved by adding masks 98, 100, prior to the etching of gate sidewall oxide 94, 96, after LDD ion implantation and CVD of the sidewall oxides. The sidewall oxide is etched and resist removed. There will be oxide on the surface of the LDD resistor regions. Because the resistors are covered by oxide, these regions will not be silicided. If selective CVD silicide is used no silicide can be deposited onto these region.

Silicide regions 102, 104 are deposited by CVD on pMOS region 79 and nMOS region 81, respectively. Appropriate ions, as previously described, are implanted to form drains 106, 108 and sources 110, 112, for pMOS region 79 and nMOS region 81, respectively. This results in the formation of LDD resistors 114, 116. An oxide layer 118, such as TEOS is deposited and etched to form contact holes for source electrodes 120, 126, gate electrodes 122, 128, and drain electrodes 124, 130, for pMOST 79 and nMOST 81, respectively. The final structure for silicide process is shown in Fig. 6.

Thus, a method and structure for providing electrostatic discharge protection for a CMOS integrated circuits, and specifically for providing a lightly doped region forming a resistor in an active region of such an integrated circuit has been disclosed. It will be appreciated that further variations and modifications thereof may be made within the scope of the invention as defined in the appended claims.

## Claims

1. A method of fabricating a CMOS device having improved electrostatic discharge protection properties, comprising:
preparing a silicon substrate;
forming an n-well for a pMOS active region;
forming a p-well for an nMOS active region; and
implanting ions to form a lightly doped drain series resistor in at least one of the active regions.

2. The method of claim 1 wherein said implanting includes implanting n-type ions in the nMOS active region to form an nLDD region and implanting p-type ions in the pMOS active region to form a pLDD region.

3. The method of claim 2 wherein said implanting n-type ions includes implanting ions taken from the group of ions consisting of phosphorous ions and arsenic at an energy of between 10 keV and 50 keV, at a dose of between 1 x 10¹² cm⁻² and 1 x 10¹⁴ cm⁻².

4. The method of claim 2 wherein said implanting p-type ions includes implanting ions taken from the group of ions consisting of boron ions and BF₂ ions at an energy of between 10 keV and 50 keV, at a dose of between 1 x 10¹² cm⁻² and 1 x 10¹⁴ cm⁻².

5. The method of claim 2 which further includes masking portions of the nLDD region and pLDD region over the area of the LDD drain series resistors and siliciding the nonmasked portions of the active regions.

6. The method of claim 1 which further includes forming an oxide layer over the active regions, implanting ions to form drain and source regions in each of the active regions, depositing an insulating layer over the structure, and metallizing the structure.

7. A method of fabricating a CMOS device having improved electrostatic discharge protection properties, comprising:
preparing a silicon substrate;
forming an n-well for a pMOS active region;
forming a p-well for an nMOS active region; and
forming a gate oxide layer over the active regions,
forming a gate on the gate oxide layer;
implanting ions to form a lightly doped drain series resistor in at least one of the active regions;
implanting ions to form drain and source regions in each of the active regions, depositing an insulating layer over the structure; and
metallizing the structure.

8. The method of claim 7 herein said implanting ions to form a lightly doped drain series resistor includes implanting n-type ions in the nMOS active region to form an nLDD region and implanting p-type ions in the pMOS active region to form a pLDD region.

9. The method of claim 8 wherein said implanting n-type ions includes implanting ions taken from the group of ions consisting of phosphorous ions and arsenic ions at an energy of between 10 keV and 50 keV, at a dose of between 1 x 10¹² cm⁻² and 1 x 10¹⁴ cm⁻².

10. The method of claim 8 wherein said planting p-type ions includes implanting ions taken from the group of ions consisting of boron ions and BF₂ ions at an energy of between 10 keV and 50 keV, at a dose of between 1 x 10¹² cm⁻² and 1 x 10¹⁴ cm⁻².

11. The method of claim 7 which further includes masking portions of the nLDD region and pLDD region over the area of the LDD drain series resistors and siliciding the nonmasked portions of the active regions.

12. In a CMOS device having a pMOST and an nMOST therein, an electrostatic discharge protection structure comprising:
an electrostatic triggering structure to uniformly trigger both pMOST and nMOST output to protect against positive and negative electrostatic discharge events.

13. The CMOS device of claim 12 wherein said electrostatic triggering structure includes a lightly doped resister in series with a drain structure of at least one of the transistors.

14. The CMOS device of claim 13 which includes a nLDD resistor in the nMOST and a pLDD resistor in the pMOST.

15. The CMOS device of claim 14 wherein said nLDD resistor has a concentration of ions taken from the group of ions consisting of phosphorous ions and arsenic ions of between about 1 x 10¹⁸ cm⁻³ and 1 x 10²⁰ cm⁻³.

16. The CMOS device of claim 14 wherein said pLDD resistor has a concentration of ions taken from the group of ions consisting of boron ions and BF₂ ions of between about 1 x 10¹⁸ cm⁻³ and 1 × 10²⁰ cm⁻³.
